# EUROPEAN PATENT APPLICATION

(11) **EP 0 790 642 A2**
(43) Date of publication of application: **20.08.1997**
(21) Application number: 97300666.1
(22) Date of filing: 03.02.1997
(51) Int. Cl.: H01L 21/306, H01J 37/32, C23C 16/44

(54) **Method and apparatus for removing contaminant particles from surfaces in semiconductor processing equipment**

(30) Priority: 02.02.1996 US 595712
(71) Applicant: APPLIED MATERIALS, INC., Santa Clara, California 95054-3299 (US)
(72) Inventor: Huo, David Datong, Campbell, California 95008 (US)
(74) Representative: Bayliss, Geoffrey Cyril

(57) **Abstract**

The disclosure relates to an apparatus and method for removing particles from a processing environment with static electricity and, more particularly, to an electrode assembly (34) and method for removing electrically conducting and dielectric contaminant particles from the surface of a substrate. Electrically conducting particles are removed by charging the particles with an ionised gas and subjecting them to an electrostatic field. The electrode assembly (34) may operate in a dedicated chamber (26) or be incorporated into a transfer station or other wafer handling equipment within a cluster tool (10).

## Description

The present invention relates generally to an apparatus and method for removing particles from a processing environment by subjecting the particles to an electrostatic field. More particularly, the present invention relates to an apparatus and method for removing conductive, semiconductor and dielectric particles from surfaces within a semiconductor substrate processing system and from the surface of semiconductor substrates by subjecting the particles to an electrostatic field.

The advent of higher packing densities, in large scale integration (LSI), very large scale integration (VLSI) and now ultra large scale integration (ULSI), has incrementally shrunk line widths and thereby necessitated ultra clean processes and manufacturing processing areas. Particle contamination of substrates adversely affects the integrity of integrated circuit devices formed thereon.

Semiconductor devices are commonly manufactured by sequentially performing a number of process steps to an exposed surface of the semiconductor substrate. The process steps typically include implanting ions in the semiconductor material immediately below the exposed surface, depositing films on the exposed surface by process such as chemical or physical vapor deposition or etching selected portions of the substrate and deposited films. Such processes generally are performed inside air-tight chambers operating at interior gas pressures below atmospheric pressure.

A continuing problem in developing and using semiconductor fabrication processes is to prevent spurious particulates from being deposited on the semiconductor devices. This problem is especially difficult to address because it is difficult to detect the presence of particulates only a few microns in diameter and even more difficult to determine the source or cause of the particulates. Of course, there are many different sources contributing to particulates in semiconductor fabrication.

One of the first and perhaps most critical factors in manufacturing integrated circuits on semiconductor substrates is the crystallographic, physical, and chemical cleanliness of the starting substrate or slice, and the subsequent maintenance of this clean condition throughout the fabrication process. The raw substrate, after being polished, must be cleaned to remove any residue left on the substrate from the polishing operation. Complete cleaning of, and maintenance of the clean condition, substrate surfaces requires that particulate materials, organic films, and adsorbed metal ions be removed from the substrate and the processing environment. Most methods of cleaning substrates require immersion of the substrate in liquid baths or sprays. Ultrasonic agitation or brush scrubbing is another method which may be used to clean the substrate. Another method of cleaning a substrate is temperature vapor etching or low pressure sputter etching. However, care must be taken to prevent the cleaning materials from leaving particulate materials on the surface of the substrate. Organic solvents have also been employed to clean substrates, but they sometimes leave a residue on the substrate surface. As a result of the problems associated with these processes, high purity water is ordinarily the last stage of a cleanup following an oxidizing acid etch to remove any organic material remaining on the surface of a substrate as a result of previous cleaning steps.

The advent of production worthy chemical mechanical polishing methods of removing deposited materials for damascene and other circuit-forming processes has led to the need to remove accumulated slurry and polishing by-products as intermediate device process steps, not just as the final step in raw substrate, i.e. pre-film layer, processing. Such polishing leaves residues which must be completely removed from the substrate.

Substrate surface contaminants may be generally classified as inorganic or organic. Inorganic atomic impurities, such as heavy metals like gold, copper, iron and magnesium, reduce the lifetime of semiconductor devices in which they are incorporated. Sources of these contaminants include chemicals, such as polishing equipment and media, acid etchants and the materials forming the process equipment itself. Etchants frequently contain contaminants which may be deposited on the substrate, or which have been removed from the substrate surface and are in suspension, and which may redeposit onto the surface of the substrate. One method of removing etchant based contaminants is to use solutions containing acids and complexing agents to dissolve the heavy metals and form soluble complexes with the ionic form of the contaminants, thereby preventing plating or redeposition of the contaminants onto the wafer from the cleaning solution.

Other inorganic impurities, such as alkali ions of sodium and potassium, are particularly detrimental to circuit performance, since these ions may form mobile charges at the silicon/oxide interface of a circuit device. These mobile charges can move due to electric fields or temperature changes, during processing or in the completed device, thus producing inversion layers, leakage, and device instabilities. A typical method of removing these contaminants is to chemically clean or etch the surface of the semiconductor substrate.

Organic contaminants, normally photoresist residues, oils (fingerprints) and waxes (from the polishing process) are usually adsorbed on the surface of the substrate where they can interfere with subsequent lithography and deposition steps and thereby create defective devices. These contaminants are best removed by cleaning the substrate in a hot sulfuric acid (H₂SO₄) or ammonium hydroxide (NH₄OH) cleaning solution.

The chemical and mechanical processes currently available for cleaning semiconductor substrates have certain limitations. First, they are mostly limited to the cleaning of raw substrates, i.e., substrates on which no circuit fabrication steps have yet been performed. Further, even after completion of these processes, the semiconductor substrate may still not be sufficiently clean for processing into electronic devices. Typical pre-cleaning of substrates removes only the oxide layer that can form when the substrate is exposed to oxygen. Degas processes generally only remove gases and vapors, such as water vapor, from the surface pores of the substrate and do not remove particles which remain on the surface of the substrate. Applicants have found that none of the equipment or processes currently available are capable of removing particles from the surface of a semiconductor substrate without the removing agent making physical contact with the processed surface of the substrate and without the risk of inherent redeposition of particles suspended in the cleaning solution onto the substrate.

Furthermore, once a cleaned substrate is subjected to a device fabrication environment, conductive, semiconductor and dielectric particles are continually being generated by the movement of the substrate and of the equipment, such as by movement of robot arms, opening and closing of slit valves, raising and lowering of support members, and the interaction therebetween. The cleaning processes mentioned above are typically not compatible with semiconductor processing environments and are limited to applications outside of the processing chambers. Additionally, exposure of a partially or fully formed device to most of the cleaning regimens is, at best, only detrimental to the resulting device performance and reliability. At the present time, there are no processes available which can effectively remove particles generated during the fabrication of semiconductor devices from the surface of semiconductor devices without risking destruction or detriment to a fully or partially formed integrated circuit, or which may be performed in the semiconductor device process environment.

Therefore, there remains a need for an apparatus and process for removing contaminant particles from within a processing system, from the substrate or from fully or partially formed semiconductor device surfaces without introducing other contaminants into the processing system. It would be desirable for this apparatus and process to remove all particulate conductive materials, including heavy metals, all particulate semiconductor materials and all particulate dielectric materials, such as free, i.e. non-continuous with the wafer, silicon, from the semiconductor surface before processing. Furthermore, it would be desirable to have an apparatus and process that removes particles generated within the semiconductor processing chamber from the semiconductor substrate surface prior to further processing of the substrate and without exposing the-substrate to the ambient environment.

The present invention provides an apparatus for the electrostatic collection of contaminant particles by providing an electrode plate, a dielectric layer formed on the surface of the electrode plate, and means for positioning a substrate surface to be cleaned and the dieiectric covered metal electrode plate in a spaced relationship, wherein a voltage source applies sufficient voltage potential between the electrode and the substrate to effect movement of contaminant particles from the substrate surface to the electrode plate. In the most preferred aspect of the invention, the particles are collected on the plate, preferably on the dielectric surface thereof.

The present invention also provides an apparatus for the electrostatic collection of contaminant particles, including a chamber having a substrate receiving surface for placement of a substrate thereon and filled with an ionizable gas, an electrode plate positioned within the chamber and electrically insulated from the chamber, wherein a voltage source applies sufficient voltage between the electrode and the substrate to cause movement of particles from the substrate and a dielectric layer formed on the surface of the electrode plate, the layer having sufficient thickness to prevent excessive transfer of electrons from particles thereon to the electrode plate. In the most preferred embodiment, the particles are collected on the electrode plate, preferably in the dielectric layer formed thereon.

The present invention further provides a method for removing contaminant particles from the surface of a substrate, comprising the steps of: positioning an electrode and a substrate in a spaced relation; applying an electrical potential between the electrode and the substrate to form an electrostatic field therebetween; and transferring the contaminant particles from the substrate surface to the electrode surface.

The present invention additionally provides a method for removing contaminant particles from the surface of a substrate, comprising the steps of: positioning a substrate within a chamber on a substrate receiving surface, wherein the chamber contains an ionizable gas; providing an electrical potential between an electrode and a substrate to form an electrostatic field therebetween; ionizing the ionizable gas; bombarding the contaminant particles with the ionized gas to transfer an electrical charge to the contaminant particles; and moving the charged contaminant particles from the substrate surface to the electrode.

So that the manner in which the above recited features, advantages and objects of the present invention are attained can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
Figure 1 is a top view of a cluster tool for processing semiconductor wafers;
Figure 2 is a cross-sectional view of a representative chamber having an electrostatic particle remover positioned over a substrate;
Figure 3 is a top view of the circular electrostatic particle remover of Figure 2;
Figure 4 is a partial cross-sectional view of a pair of electrostatic particles removers positioned on either side of a substrate; and
Figure 5 is a partial top view of a wafer on a robot arm passing through a slit valve and under an electrostatic particle remover as the wafer approaches a substrate support member.

The present invention provides an apparatus and method for removing particles from a processing environment by electrostatically attracting particles within the environment to an electrically biased member located within the processing environment. More particularly, the present invention provides an apparatus and method for removing conductive, semiconductive and dielectric particles from the surface of semiconductor substrates and from within a processing environment by subjecting the particles to an electrostatic field, preferably without forming a plasma from any gas in the processing environment, to attract the particles to a position other than on the substrate. The particles are attracted away from the substrate surface by the biased member forming an electrostatic field and are preferably contained on the surface thereof until the system is shut down for routine maintenance. It is preferred that the electrostatic field be provided by one or more electrodes of any size and shape that can be positioned or passed near the contaminated surface or within a processing environment to attract any particles located therein. Preferably, the substrate support member is grounded.

In a preferred implementation of the invention, a charge is applied to contaminant particles by placing a biased member in close proximity to the contaminated surface on which the particles are located. Preferably, a gas is maintained between the plate and the contaminated surface and at least a portion of the gas is ionized by the potential between the surface and the biased member. The ionized gas charges the conductive and semiconductive particles, as will be described further herein, to enhance electrostatic sweeping of conductive and semiconductive particles from the contaminated surface within the processing equipment onto the biased member. The field created by the biased member creates an electric dipole in dielectric particles on the contaminated surface, which enables electrostatic sweeping of dielectric particles from the contaminated surface onto the biased member. Thus, the biased member can remove conductive, semiconductive and dielectric particles from the processing environment without contacting the contaminated surface with a particle removing medium.

The electrostatic particle remover of the present invention can be used at any pressure, ranging from extremely high pressures to very low pressures. However, it should be recognized that the efficiency with which conducting particles are collected by an electrostatic field under a given potential is greater at atmospheric pressure than at much reduced pressures, such as the 10⁻⁹ torr base pressure used in certain semiconductor manufacturing processes, because a greater amount of gas is available to be ionized and thus charge the particles. However, the reduction in efficiency is very slight and ultimately the conducting and semiconductive particles, as well as the dielectric particles, are attracted to the electrode, even in a near perfect vacuum environment.

Furthermore, most conducting particles are not perfectly conducting and exhibit some small migration of charge or small dielectric effect when placed under an electrostatic field. This small migration of charge allows a conducting particle to be collected in a similar manner as a dielectric particle. Therefore, in accordance with the present invention, attraction of conducting and semiconducting particles is not dependent upon the presence of an ionized gas, although the presence of an ionized gas is preferred.

### I. Attraction of Conducting and Semiconducting Contaminants

When gas ions are present and collide with conducting or semiconducting particles in the chamber, the ions associate with the conductive/semiconductive particle surfaces to form a surrounding layer on the particles with a negative charge. The negatively charged particles are then attracted to the positively charged electrode. If the electrode has sufficient positive voltage and the particles have acquired a sufficiently negative charge in relation to their mass to overcome gravity and any opposing electrostatic charges that may be present on the contaminated surface or otherwise within the chamber, then the particles will jump from the contaminated surface to the electrode. While the present invention could be operated at a wide range of voltages, the preferred voltage is in the range from about 1,000 V(+)DC to about 15,000 V(-)DC with the most preferred voltage being about 5,000 V(+)DC with a spacing between the electrode and substrate of about one-half (0.5) inch. The current applied to the electrode is preferably limited to about 0.5 milliamperes by using a high-resistance resistor, such as a one megaohm resistor, between the voltage source and the electrode.

### II. Attraction of Dielectric Contaminants

The electrode also attracts dielectric particles because the dielectric particles located within the electrostatic field become polarized with a negatively charged region concentrating on the particle surface adjacent the positive electrode and a positively charged region on the particle surface furthest from the positively charged electrode. Because the positively charged electrode is closer to the negatively charged surface of the dielectric particle than to the positively charged surface thereof, there is a net attraction on dielectric particles in the direction of the positively charged electrode. If the surface which is to be swept (or cleaned), such as a substrate surface, has acquired some small electrical charge which electrostatically impedes migration of particles therefrom, the surface charge can be neutralized by blowing an ionized gas over the surface . Typically, processing chambers are equipped with an inert gas supply, such as an Argon gas supply, to provide sputtering gas to the chambers. The argon gas adjacent the electrode is ionized by the electrostatic field formed adjacent the biased electrode. Upon contact with an oppositely charged surface, such as the surface of a substrate, the charge on the gas ion will be released to the charged surface, thereby neutralizing the surface charge.

The electrode of the present invention preferably has a dielectric layer formed on at least one surface thereof to prevent attracted particles from transferring their charge to the electrode and falling back onto the surface from which the article has been removed or another surface within the chamber. The dielectric layer will polarize with a negatively charged region concentrating adjacent the conducting positive electrode and a positively charged region concentrating near the outer surface of the dielectric layer opposite the conductive electrode. In this manner, the dielectric-coated electrode forms an electrostatic field which attracts conductive, semiconductive and dielectric particles to the surface thereof, but the insulative properties of the dielectric layer prevent the particles from readily transferring their charge to the electrode plate which would result in a loss of attractive force between the particles and the electrode. Preferred materials for the dielectric layer include polyamides, such as those available from DuPont of Wilmington, Delaware under the trade name KAPTON which may be applied as a 1-2 mil sheet. The electrode is preferably a conductive metal, although other materials which, when positively charged in the configuration of the invention, will establish an attractive pull on particles are contemplated herein.

### III. Collection of Particles Within a Cluster Tool

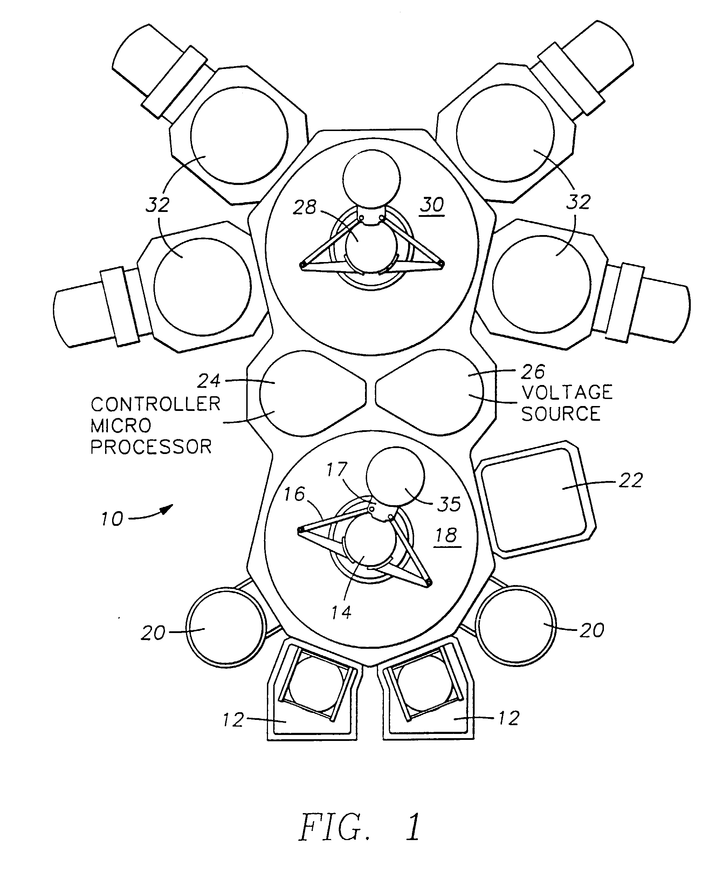

Referring to Figure 1, a top view of a cluster tool 10 for processing substrates is shown. Typically, substrates are introduced and withdrawn from the cluster tool 10 through a cassette loadlock 12. A robot 14 having a blade 17 is located within the cluster tool 10 to move the substrates through the cluster tool. One robot 14 is typically positioned in a buffer chamber 18 to transfer substrates between the cassette loadlock 12, degas wafer orientation chamber 20, preclean chambers 22, 24 and cooldown chamber 26. A second robot 28 is located in transfer chamber 30 to transfer substrates to and from the cooldown chamber 26 and processing chambers 32. The specific configuration of chambers in Figure 1 is merely illustrative and should not be taken as limiting the application of the present invention.

Typically, a substrate processed in the cluster tool 10 is passed from the cassette loadlock 12 to the buffer chamber 18 where the robot 14 first moves the substrate into a degas chamber 20, then into preclean chamber 22, and then into a cooldown chamber 26. From the cooldown chamber 26, the robot 28 typically moves the substrate into and between one or more processing chambers 32, before returning the substrate back to the cooldown chamber 26. It is anticipated that the substrate may be processed or cooled in one or more chambers any number of times in any order to accomplish fabrication of a desired structure on the substrate. The substrate is removed from the cluster tool 10, following processing, through the buffer chamber 18 and then to the loadlock 12.

The electrostatic particle remover of the present invention mav be advantageously incorporated into a cluster tool at any one or more locations therein, it being understood that exposure of the remover to process environments, such as plasmas, sputtered materials and chemical vapors used to etch or deposit film layers, is detrimental to the performance and longevity of the remover. Preferably, the electrostatic particle remover is positioned within the cooldown chamber 26 to remove particles from a substrate prior to and following desired processing steps of the substrate. As another example, the electrostatic particle remover may be made part of the robot arm and thereby be moved about the chambers within which the robot communicates to remove particles in various chambers and from the surfaces of support members and electrostatic chucks. As yet another example, an electrostatic particle remover may be used within both the buffer chamber 18 and the transfer chamber 30 for particle removal from substrates prior to and between each process step. Some specific embodiments of the use of the present invention will be described in detail below.

### IV. Specific Embodiments of the Electrostatic Particle Remover

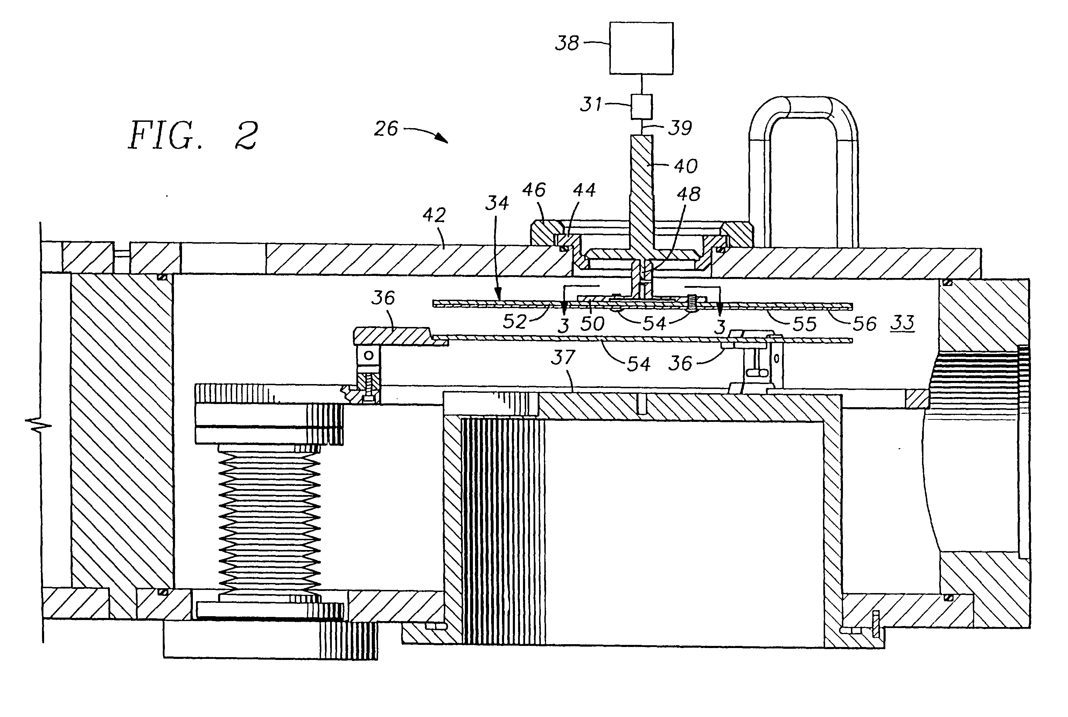

In one embodiment of the present invention shown in Figure 2, a cross-sectional view of a representative chamber 26 is shown having an electrostatic particle remover positioned over a substrate 35. The chamber 26 has an electrode 34 positioned adjacent or passed near a contaminated surface 35 or environment 33 to remove particles, such as heavy metals or dielectric materials. The electrode 34 forms an electrical corona discharge of electrons (e⁻) that associate with gas disposed between the electrode 34 and the substrate 35, such as Argon (Ar), to form ions, such as Argon ions (Ar⁻). The ionized gas moves throughout the chamber and bombards particles located on surfaces within the chamber, including the surfaces of semiconductor substrates and on the inner walls of the chamber itself. The degree to which the ions bombard the contaminated surface and particles located thereon is increased by positioning the electrode 34 relative to the surface so that the corona generates the ions adjacent the surface of substrate 35. It is generally preferred that the distance between the electrode 34 and the surface be no more than about two inches, with the most preferred distance being about one-half (0.5) inch. While an electrode 34 having a negative voltage is within the scope of the present invention, it is generally less preferred for removing conducting and semiconducting particles, such as heavy metals, since it is more difficult to attract these particles with a positively ionized gas than with a negatively ionized gas.

The chamber includes lift pins 36 for lifting a substrate 35 from a robot arm (shown in Figure 1) and lowering the substrate onto a substrate receiving surface 37. While such elements of a chamber are generally preferred so that the robot arm may be removed from the processing chamber before processing begins, it should be understood that any apparatus or method for passing the substrate under the electrostatic particle remover 34 is sufficient for use with the present invention.

A positive voltage source 38 is electrically connected to an electrostatic particle remover 34 through a high resistance resistor 31 and a conducting wire 39. The wire 39 is coupled to a conducting member or feed-through 40, preferably made of stainless steel, that is electrically insulated from the wall 42 of the chamber 26 by an insulative collar 44. The collar 44 and conducting member 40 are then secured to the wall 42 by a retaining ring 46 to form an air tight seal. Such feed-through arrangements are well known in the art.

The conducting member 40 has a pin 48 extending into the chamber 26 for coupling with an electrically conducting base member 50. The base member 50 is preferably made of aluminum. A metal electrode plate 52, preferably made of stainless steel, is coupled to the base member 50 with insulated rivets 54. The electrode plate 52 has a surface 56 that is coated with a thin dielectric layer 55 having a thickness sufficient to prevent electrical conduction therethrough, preferably having a thickness as low as about 0.005 inch. The preferred materials for the dielectric layer 55 are those which experience very low outgassing under a vacuum, such as the polyamides discussed above.

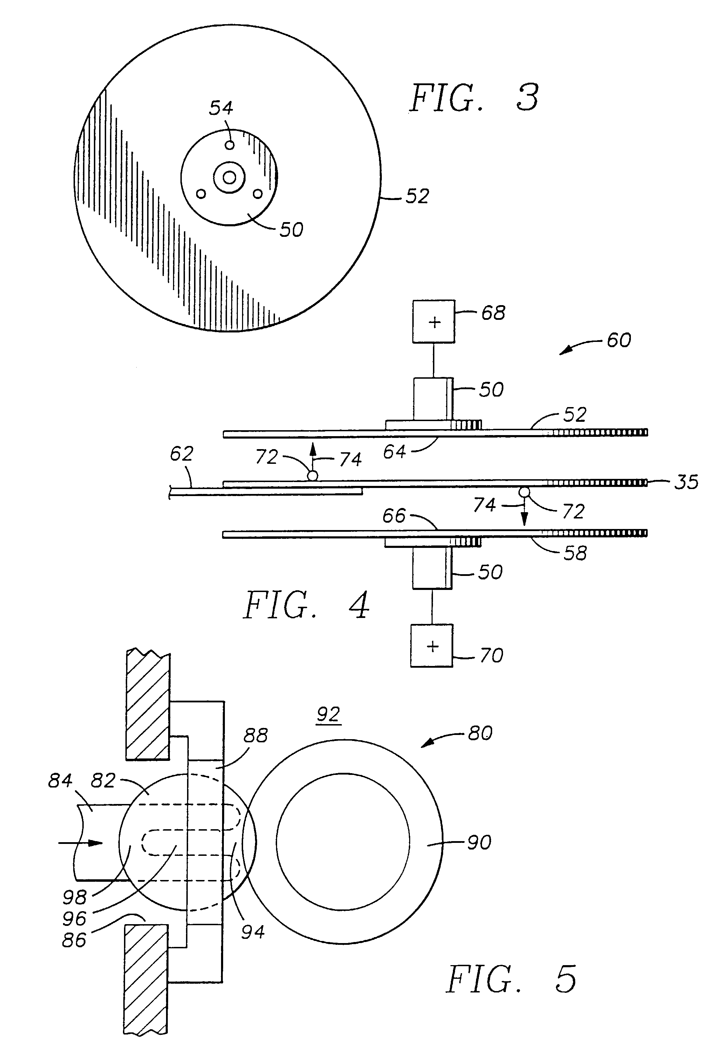

Referring to Figure 3, a top view of the circular electrostatic particle remover of Figure 2 is shown. While the electrode plate 52 may be formed in virtually any shape, it will typically be shaped to match the shape of the substrates being processed, which in the case of semiconductor substrates is typically circular. The base member 50 is shown to be disposed near the center of the electrode plate 52, but may contact the plate at any position across its surface. It is preferred that the base member 50 and electrode plate 52 be secured together in at least three equally spaced radial positions by insulating rivets 54.

While a preferred electrode has a substantially similar area and shape as the substrate 35 to be cleaned, it should be noted that the size and shape of the electrode 34 is only secondarily important so long as the entire area of the substrate 35 passes close to the electrode 34 so that particles can be attracted to the electrode. For example, the electrode could be in the form of a narrow strip adjacent a slit valve 50 such that the entire surface of a substrate 35 moved through the slit valve passes near the electrode 34 to remove particles therefrom.

In another embodiment, a plurality of electrodes are provided within a processing chamber or integrated multi-chamber system so that both surfaces of a substrate are located adjacent a particle removing electrode and can be cleaned. The electrodes may be located throughout a cluster tool and adjacent the top and bottom surfaces of a substrate located in the chamber to enable removal of particles from both sides of a substrate, including those particles located on the back side of the substrate. Particles may be generated on the surface of an electrostatic chuck as a substrate is positioned thereon. Particles located on the electrostatic chuck may be attracted to the backside of the substrate as the substrate is released from the electrostatic chuck, which facilitates particle removal from the electrostatic chuck itself by using the substrate backside as a particle carrier. Electrostatic chuck are used in semiconductor processing chambers to hold individual semiconductor substrate on a chamber structural member, such as a substrate support member or pedestal.

An electrostatic chuck typically includes at least a dielectric layer and an electrode, which may be located on a chamber support member or formed as an integral part of the chamber support member. A semiconductor substrate is placed in contact with the dielectric layer, and a direct current voltage is placed on the electrode to create the electrostatic attractive force to grip the substrate on the chuck. An electrostatic chuck is particularly useful in vacuum processing environments in which the maximum differential pressure that can be established between the low pressure chamber and the face of the chuck is insufficient to firmly grip the substrate on the chuck, or where mechanical clamping of the substrate to the chuck is desirable. The electrostatic chuck, having a voltage source connected thereto, will attract dielectric and conducting particles present in the chamber, including those present on the substrate or generated within the chamber. These particles, when attracted to the backside of the substrate, i.e. the side of the substrate positioned against the electrostatic chuck, will be removed from the wafer electrostatic chuck environment when the substrate backside passes over the remover.

Referring to Figure 4, a partial cross-sectional view of a pair of particle removers 52,58 positioned on either side of a substrate 35 is shown. The robot blade 62 holds the substrate 35 thereon and passes between the electrode plates 52,58 each having a dielectric layer formed on the surfaces 64,66 facing the substrate, respectively. The electrode plates 52,58 are each electrically coupled to a common or separate voltage source 68,70. As described above with regard to a single electrode apparatus, such as that shown in Figure 2, each electrode plate 52, 58 attracts conductive, semiconductive and dielectric particles 72 from the wafer surface in the direction of the arrows 74.

In accordance with another aspect of the invention, particle remover 34 (see Figure 2) located in one chamber of a cluster tool may be used to sufficiently charge a moveable member, such as a substrate, robot blade 17 (see Figure 1) or a remover attached to the blade so that when the moveable member is positioned adjacent an electrostatic chuck or within other areas of the cluster tool, the particles present on the surfaces therein are attracted to the moveable member. The moveable member having collected particles thereon is withdrawn from the chamber and moved past an electrode, located within the cluster tool, so that the particles are collected thereon or removed from the cluster tool altogether. The movable electrostatic particle remover must provide a sufficient electrostatic field to overcome the forces attracting the particles to the electrostatic chuck so that the particles will be attracted away from the electrostatic chuck and onto the particle remover. It is preferred that the voltage applied to the electrostatic chuck be reduced to zero for a period of time while the movable electrostatic particle remover is positioned adjacent the surface of the electrostatic chuck forming an electrostatic field that attracts the particles from the electrostatic chuck. It may even be possible to reverse the voltage on the electrostatic chuck for a moment to eliminate any residual charge so that the attraction between the particles and the electrostatic chuck is minimized.

Referring to Figure 5, a partial top view of a wafer 82 on a robot arm 84 is shown in position for passing through a slit valve 86 and under an electrostatic particle remover 88 as the wafer 82 approaches a substrate support member 90 located in vacuum chamber 92. The particle remover 88 is a narrow strip spanning a width sufficient to collect particles from the entire wafer surface. As the wafer 82 is passed under the electrode 88, particles are first collected from the front region 94 of the wafer (relative to the support member 90) then, as the wafer 82 progresses into the chamber 92, from the middle region 96 and back region 98. It should be recognized that an additional electrode could be placed below the slit valve 86 to remove particles from the bottom side of the substrate in the same manner.

In another embodiment of the present invention, an electrode plate 34 of a stationary electrostatic particle remover is positioned in a cluster tool 10 (shown in Figure 1) in the path of a substrate 35 being transferred by a robot 14, 18 arm into and out of the various chambers within the cluster tool 10 to remove particles from various surfaces, such as the surface of a substrate. As the robot arm transfers a substrate 34 from a loadlock 12 to a location in a cluster tool 10 having the electrostatic particle remover therein, the substrate 35 will be positioned a spaced distance directly below the electrode plate 34 for a period of time that may be as short as a fraction of a second, and may be as long as convenient with respect to the movement of substrates through the cluster tool, to remove particles from the surface thereof. After the particles have been removed from the substrate surface, the robot arm then transfers the substrate 35 to another chamber for further processing.

It is preferred that the robot arm be made of an insulating material, such as ceramic or have a dielectric layer formed thereon, and that the empty and/or idle robot arm be periodically passed under the electrode plate 34 to remove particles therefrom and to establish an electrical charge on the robot blade to enable the robot blade to attract particles throughout the system. The charged robot blade continuously attracts particles in locations throughout the cluster tool where the blade is moved. As one example, the robot blade may be moved over the surface of an electrostatic chuck used in certain applications to secure a substrate in position for processing. The surface of an electrostatic chuck is typically biased forming an electrostatic field which attracts and secures a substrate thereto and as a result tends to collect particles. The charged robot blade attracts particles from the surface of the electrostatic chuck thereby cleaning its surface. In this manner, the blade functions as a mobile particle remover to remove particles throughout the processing equipment. The robot blade is cleaned by passing it under the electrode plate 34 having sufficient electrostatic force to overcome the electrostatic charge on the blade and lift any particles collected thereon from the blade.

### V. Removal of Particles from the Electrode

The voltage applied to the electrode 34 is preferably maintained, thereby attracting particles, until a plurality of substrates have been processed and moved to a location where particles released from the electrode will not redeposit in the processing equipment or on a substrate located therein. It is preferred that the voltage applied to the electrode 34 be maintained until other components of the substrate processing apparatus or cluster tool are shut down. It is possible that the electrode may be utilized over extended periods of time without cleaning, particularly in applications where the amount of particulate contamination on the substrate and generated within the processing environment is minimal.

It is preferred that the electrode itself be cleaned periodically, for example by positioning a sacrificial substrate or collection pan below the electrode 34 and removing, reducing or reversing the voltage applied to the electrode to cause release of the particles from the electrode 34 and attraction of the particles to the sacrificial substrate or collection pan. Preferably, the collection pan is charged in order to apply an attractive force on the particles sufficient to overcome any residual charge on the surface of the positive electrode itself. After the particles have been transferred onto the collection pan, the pan is withdrawn from the chamber and cleaned. It is anticipated that the electrode 34 may also be periodically chemically or mechanically cleaned to remove accumulated particles and reduce the likelihood of contamination within the system.

While the foregoing is directed to the preferred embodiment of the present invention, other and further embodiments of the invention may be devised without departing from the basic scope thereof. The scope of the invention is determined by the claims which follow.

## Claims

1. An apparatus for the electrostatic collection of contaminant particles from a surface in semiconductor substrate processing equipment, comprising:
a) an electrode plate having an electrical connection to a voltage source;
c) a dielectric layer formed on the surface of the electrode plate; and
d) a positioning member for providing a spaced relationship between the surface and the electrode plate, wherein the voltage source applies sufficient voltage between the electrode and the surface to collect contaminant particles from the surface.

2. The apparatus of claim 1 wherein the surface is a substrate surface.

3. The apparatus of claim 2, wherein the positioning member comprises a robot arm for passing a substrate near the electrode plate.

4. The apparatus of claim 2, wherein the positioning member comprises a substrate receiving surface positioned adjacent and substantially parallel to the electrode plate and a robot arm for placing a substrate on the substrate receiving surface.

5. The apparatus of claim 2, wherein the positioning member comprises a substrate receiving surface and a robot arm having the electrode plate mounted thereon, the substrate receiving surface receiving a substrate thereon, the robot arm passing the metal electrode plate into a spaced relation with the substrate surface.

6. The apparatus of claim 1 wherein the electrode is metal, having a dielectric layer thereon.

7. An apparatus for the electrostatic collection of contaminant particles, comprising:
a) a chamber, having an ionizable gas therein and having a substrate receiving surface for placement of a substrate thereon;
b) an electrode positioned within the chamber and electrically insulated therefrom, the electrode having an electrical connection to a voltage source, wherein the voltage source applies sufficient voltage to collect contaminant particles from the chamber; and
c) a dielectric layer on the surface of the electrode, the layer having sufficient thickness to prevent transfer of electrons from charged particles collected thereon to the electrode plate.

8. The apparatus of claim 7, wherein the dielectric layer has a surface positioned adjacent and substantially parallel to the substrate.

9. The apparatus of claim 8 wherein the electrode surface includes a robot blade surface.

10. The apparatus of claim 8, wherein the electrode is a metal plate.

11. The apparatus of claim 7, further comprising a slit valve for placing a substrate into the chamber.

12. The apparatus of claim 7, wherein the voltage potential between the electrode and the substrate is between about 1,000 and about 15,000 volts.

13. The apparatus of claim 7, wherein the voltage potential between the electrode and the wafer is about 5,000 volts.

14. A method for removing contaminant particles from the surface of a substrate, comprising the steps of:
a) positioning an electrode and a substrate into a spaced relation;
b) applying an electrical potential between the electrode and the substrate to form an electrostatic field therebetween; and
c) transferring the contaminant particles from the substrate surface to the electrode.

15. The method of claim 14, wherein the electrode compnses a metal electrode plate coated with a dielectric material.

16. The method of claim 14, further comprising the steps of:
d) ionizing a gas in the space between the electrode and the substrate; and
e) bombarding the contaminant particles with the ionized gas to transfer an electrical charge to the contaminant particles.

17. The method of claim 14, wherein the electrical potential between the electrode and the substrate is between about 1,000 Volts and about 15,000 Volts.

18. The method of claim 14 wherein the electrode is contained in a chamber.

19. A method for removing contaminant particles from the surface of a substrate, comprising the steps of:
a) positioning a substrate within a chamber on a substrate receiving surface, wherein the chamber contains an ionizable gas;
b) providing an electrical potential between an electrode and a substrate to form an electrostatic field therebetween;
c) ionizing the ionizable gas;
d) bombarding the contaminant particles with the ionized gas to transfer an electrical charge to the contaminant particles; and
e) moving the charged contaminant particles from the substrate surface to the electrode.

20. The method of claim 19, wherein the electrode comprises a metal electrode plate having a surface positioned adjacent and substantially parallel to the substrate receiving surface.

21. The method of claim 19, wherein the electrical potential between the electrode and the wafer is between about 1000 and about 6000 volts.

22. The method of claim 19, wherein the electrical potential between the electrode and the wafer is about 5000 volts.

23. The method of claim 19, further comprising the steps of:
f) withdrawing the substrate from the chamber;
g) positioning a dust pan over the substrate receiving surface;
h) eliminating the electrical potential to release the contaminant particles from the electrode;
I) collecting the contaminant particles in the dust pan; and
j) withdrawing the dust pan and particles from the chamber.

24. A method for collecting contaminant particles in a cluster tool, comprising the steps of:
a) providing a charge on an insulative member;
b) moving the charged insulative member within the cluster tool;
c) collecting contaminant particles within the cluster tool onto the charged insulative member.

25. The method of claim 24 wherein the insulative member is a component of a robot.

26. The method of claim 25 wherein the component of the robot is a robot blade.

27. The method of claim 26 further comprising the step of passing the robot blade near an electrode within the cluster tool to charge the robot blade.

28. The method of claim 26 further comprising the step of passing the robot blade near an electrode within the cluster tool to clean the robot blade.

29. The method of claim 26 further comprising the step of passing the robot blade near an electrostatic chuck to remove particles on the electrostatic chuck surface.

30. An apparatus for removing particulates from the interior regions of semiconductor processing equipment, comprising:
a) a collection member;
b) a biasing member connected to said collection member; and
c) a positioning member for positioning said collection member within said chamber equipment.

31. The apparatus of claim 30 wherein the collection member is a stationery member.

32. The apparatus of claim 30, wherein a collection member is movable within the processing equipment.

33. The apparatus of claim 32, wherein the processing equipment includes at least a transfer chamber, a process chamber and a substrate handling member positionable to move a substrate between said transfer chamber and said process chamber, and said positioning member is provided on said handling member.

34. The apparatus of claim 33, further including a support member on which a substrate is received and said position member has at least a first position to position said collection member adjacent said support member and a second position remote from said support member.

35. The apparatus of claim 34, wherein the support member includes an electrostatic attraction member for grasping a substrate to said support member.
